# EUROPEAN PATENT APPLICATION

(11) **EP 4 734 734 A1**
(43) Date of publication of application: **29.04.2026**
(21) Application number: 24825916.0
(22) Date of filing: 19.06.2024
(51) Int. Cl.: H10N 50/20, H01F 1/34, H01F 10/24, H01L 29/82, H01P 1/00, H01P 3/00

(54) **SPIN WAVE WAVEGUIDE STRUCTURE**

(30) Priority: 20.06.2023 JP 2023100720
(71) Applicant: SHIN-ETSU CHEMICAL CO., LTD., Tokyo 100-0005 (JP); Tohoku University, Sendai-shi, Miyagi 980-8577 (JP)
(72) Inventor: WATANABE Toshiaki, Annaka-shi, Gunma 379-0195 (JP); GOTO Taichi, Sendai-shi, Miyagi 980-8577 (JP)
(74) Representative: Schicker, Silvia
(86) International application number: PCT/JP2024/022167
(87) International publication number: WO 2024/262515

(57) **Abstract**

The present invention is a spin wave waveguide structure including: an insulating magnetic film; and a periodic conductor film disposed on at least one surface of both surfaces of the insulating magnetic film, the periodic conductor film being formed of a conductor film having a periodic structure, in which the periodic structure of the periodic conductor film is such that the conductor film is formed of an assembly of a plurality of fragment films, the fragment films are electrically insulated from each other, the insulation is due to the fragment films being separated by a plurality of holes and grooves connecting the plurality of holes or due to a non-magnetic and non-conductive material existing in at least a portion of the holes and grooves, the spin wave waveguide structure includes, on the insulating magnetic film, a portion where the periodic conductor film is present and a portion where the conductor film is not present, and the insulating magnetic film of the portion where the conductor film is not present functions as a spin wave waveguide. Accordingly, a spin wave waveguide structure capable of guiding spin waves without changing the shape of a magnetic material is provided.

## Description

### TECHNICAL FIELD

The present invention relates to a spin wave waveguide structure.

### BACKGROUND ART

In recent years, the rapid increase in the volume of information in the Internet and artificial intelligence has led to growing demands for continuous advancement in electronic devices. Performance improvement has been achieved so far through miniaturization and integration of electronic devices, but as miniaturization approaches its physical limit, the problem of heat generation has become pronounced, resulting in a situation where device performance improvement is interfered with. The heat generation is caused by Joule heating that is generated as electrons move through a conductor, and it is thought that this problem can be solved if a device capable of performing information processing without moving electrons is realized. Thus, attention has been focused on devices that use spin waves, which can propagate through an insulator that does not conduct electricity without involving the movement of electrons. However, development of devices using spin waves has gained rapid attention over the past decade, and basic components such as spin wave propagation elements and rudimentary logic elements have been steadily developed; accordingly, it can be said that the technology is still in its infancy as of 2023.

Against this background, methods and structures for realizing waveguides, which are most fundamental elements among spin wave devices (spin wave circuits), have been developed. Spin wave waveguides correspond to electrical lines (interconnects) in electronic circuits and can be considered to be essential. Note that spin waves are phase waves generated by magnetization (spin) in a magnetic body. Spin waves are also referred to as magnetostatic waves. In the description of the present specification, the term "spin wave" is a concept that also includes "magnetostatic waves".

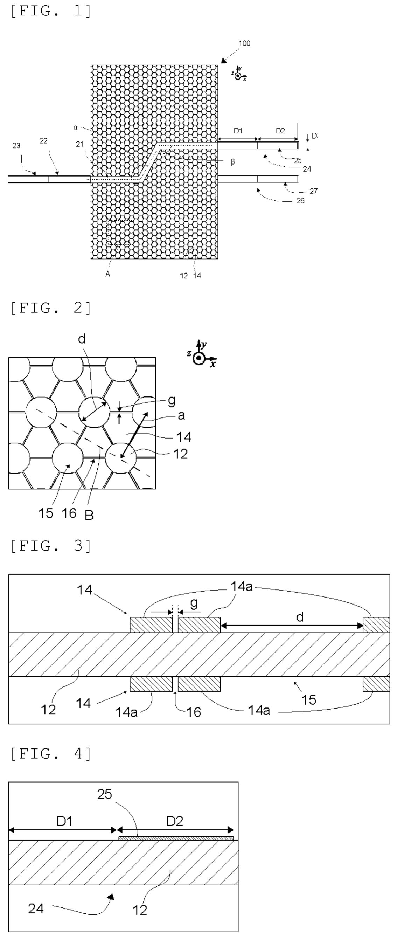

Spin waves propagate only in magnetic materials and do not propagate in air. Thus, it is possible to route spin waves by processing a magnetic material into an optional shape. Typically, a waveguide in an optional shape is produced by etching or milling a magnetic material. Non Patent Document 1 introduces an example in which a spin wave waveguide is produced by milling a magnetic material into a ψ shape as illustrated in Figure 1. Accordingly, spin waves can be routed to optional positions. However, changing the shape of a magnetic material changes its magnetization state, which in turn changes the propagation strength of spin waves, resulting in a problem that the power efficiency of a spin wave device degrades. This magnetization state change caused by a change in the shape of a magnetic body is a principle common to all magnetic bodies and cannot be avoided as long as shape change is performed.

A periodic magnetization structure can be produced by periodically forming holes in a magnetic material. Among spin waves propagating through a magnetic material with periodically formed holes, those with specific frequencies cannot propagate due to phase interference. This range of frequencies at which propagation is impossible is referred to as a bandgap. By producing a region without a periodic structure along a path in a periodic structure, it is possible to make spin waves propagate along the path. Non Patent Document 2 is a paper that experimentally demonstrated this. However, since the shape of a magnetic material is changed in Non Patent Document 2, the same problem as in Non Patent Document 1 remains, in which propagation strength of spin waves changes, resulting in significant degradation in the power efficiency of a spin wave device.

### CITATION LIST

### NON PATENT LITERATURE

Non Patent Document 1: Naoki Kanazawa, Taichi Goto, Koji Sekiguchi, Alexander B. Granovsky, Caroline A. Ross, Hiroyuki Takagi, Yuichi Nakamura, Hironaga Uchida and Mitsuteru Inoue, "The role of Snell's law for a magnonic majority gate", Scientific Reports, 7, 7898 (2017/08/11).
Non Patent Document 2: Y. Zhu, K. H. Chi and C. S. Tsai, "Magnonic crystals-based tunable microwave phase shifters", Applied Physics Letters, 105, 022411 (2014).

### SUMMARY OF INVENTION

### TECHNICAL PROBLEM

As described above, spin wave waveguides are needed to realize spin wave interconnects. Structures for producing spin wave waveguides are disclosed in Non Patent Documents 1 and 2. However, it has been found that in both structures of Non Patent Documents 1 and 2, it is necessary to change the shape of a magnetic material through processing, and thus spin wave propagation efficiency (power consumption) degrades due to shape dependency of the magnetic material. Accordingly, there has been a demand for structures for controlling the direction in which spin waves are guided without changing the shape of a magnetic material. This is the current problem with spin wave waveguides. So far, no effective structures that solve the problem have been disclosed.

In view of the circumstances, the present invention aims to provide a spin wave waveguide structure capable of guiding spin waves without changing the shape of a magnetic material.

### SOLUTION TO PROBLEM

To achieve the object, the present invention provides a spin wave waveguide structure for guiding spin waves, the spin wave waveguide structure comprising: an insulating magnetic film; and a periodic conductor film disposed on at least one surface of both surfaces of the insulating magnetic film, the periodic conductor film being formed of a conductor film having a periodic structure, wherein the periodic structure of the periodic conductor film is such that the conductor film is formed of an assembly of a plurality of fragment films, and the fragment films are such that the fragment films adjacent to each other are electrically insulated from each other, the electric insulation between the fragment films is due to the fragment films being separated by a plurality of holes and grooves connecting the plurality of holes or due to a non-magnetic and non-conductive material existing in at least a portion of the holes and grooves, the spin wave waveguide structure includes a portion where the periodic conductor film is present on the insulating magnetic film, and a portion where the conductor film is not present on the insulating magnetic film, and the insulating magnetic film of the portion where the conductor film is not present functions as a spin wave waveguide.

Such a spin wave waveguide structure is capable of guiding spin waves without changing the shape of a magnetic material. Specifically, the portion of the insulating magnetic film where the conductor film is not present can function as a spin wave waveguide, and spin wave guiding can be achieved by changing a place where the conductor film is formed, without changing the shape of the insulating magnetic film.

Here, it is preferable that the insulating magnetic film is formed of a magnetic garnet. In addition, it is preferable that the insulating magnetic film is formed of yttrium iron garnet.

Due to the insulating magnetic film being of this type, favorable spin wave guiding can be achieved.

Furthermore, the conductor film may contain at least one of copper, aluminum, gold, silver, platinum, iron, a transparent conductor, a superconductor, graphene, carbon nanotubes, an organic conductive material, and a conductive magnetic body.

In the spin wave waveguide structure of the present invention, in addition to copper, other types of conductors as described above may be used as conductor components.

Furthermore, it is preferable that the insulating magnetic film has a thickness of 1 mm or less.

Furthermore, it is preferable that the conductor film preferably has a thickness of 100 µm or less.

The constituent components of the spin wave waveguide structure of the present invention preferably have such dimensions, thereby enabling size reduction.

Furthermore, it is preferable that the spin wave waveguide structure further comprises a supporting substrate, and the insulating magnetic film and the periodic conductor film are disposed on the supporting substrate.

In this manner, by further including the supporting substrate, the spin wave waveguide structure can have excellent mechanical strength.

In this case, the supporting substrate may be at least one of a silicon substrate, a glass substrate, a garnet substrate, a dielectric substrate, a conductive substrate, an insulating substrate, a magnetic substrate, a non-magnetic substrate, a wooden substrate, and a stone substrate.

In the spin wave waveguide structure of the present invention, in addition to a silicon substrate, other types of substrates as described above can be used as the supporting substrate.

Furthermore, it is preferable that the supporting substrate has a thickness of 100 µm or more and 500 µm or less.

In consideration of strength and size reduction, the supporting substrate preferably has a thickness within such a range.

Furthermore, an input portion and an output portion for spin waves may be formed in the insulating magnetic film of the portion where the conductor film is not present.

Such a spin wave waveguide structure including the input portion and the output portion can easily input and output spin waves.

### ADVANTAGEOUS EFFECTS OF INVENTION

A spin wave waveguide structure of the present invention is capable of guiding spin waves without changing the shape of a magnetic material. Specifically, the portion of the insulating magnetic film where the conductor film is not present can function as a spin wave waveguide, and spin wave guiding can be achieved by changing a place where the conductor film is formed, without changing the shape of the insulating magnetic film.

### BRIEF DESCRIPTION OF DRAWINGS

FIG. 1 is a schematic top view illustrating an example of a spin wave waveguide structure of the present invention;
FIG. 2 is a schematic top view illustrating an example of the spin wave waveguide structure of the present invention, and is an enlarged view of a part corresponding to broken line A in FIG. 1;
FIG. 3 is a cross-sectional view illustrating an example of the spin wave waveguide structure of the present invention, and is a cross-sectional view of a part corresponding to broken line B in FIG. 2;
FIG. 4 is a cross-sectional view illustrating an example of an output portion that can be formed in the spin wave waveguide structure of the present invention;
FIG. 5 is a diagram illustrating spin wave propagation of Example;
FIG. 6 is a graph illustrating intensity distributions of spin waves measured by an output terminal (an output portion and a comparative output portion) of Example; and
FIG. 7 is a diagram illustrating spin wave propagation of Comparative Example.

### DESCRIPTION OF EMBODIMENTS

Embodiments of the present invention will be described below, but the present invention is not limited thereto.

As described above, structures for controlling the direction in which spin waves are guided without changing the shape of a magnetic material have been demanded. For this problem, the inventors found that spin wave guiding is possible through a specific structure without changing the shape of a magnetic material, thereby completing the present invention.

The present invention is a spin wave waveguide structure for guiding spin waves, the spin wave waveguide structure comprising: an insulating magnetic film; and a periodic conductor film disposed on at least one surface of both surfaces of the insulating magnetic film, the periodic conductor film being formed of a conductor film having a periodic structure, wherein the periodic structure of the periodic conductor film is such that the conductor film is formed of an assembly of a plurality of fragment films, and the fragment films are such that the fragment films adjacent to each other are electrically insulated from each other, the electric insulation between the fragment films is due to the fragment films being separated by a plurality of holes and grooves connecting the plurality of holes or due to a non-magnetic and non-conductive material existing in at least a portion of the holes and grooves, the spin wave waveguide structure includes a portion where the periodic conductor film is present on the insulating magnetic film, and a portion where the conductor film is not present on the insulating magnetic film, and the insulating magnetic film of the portion where the conductor film is not present functions as a spin wave waveguide.

The present invention will be further described with reference to the accompanying drawings. FIG. 1 is a schematic top view illustrating an example of a spin wave waveguide structure of the present invention. FIG. 2 is an enlarged view of a part surrounded by broken line A in FIG. 1. FIG. 3 is a cross-sectional view of a part along broken line B in FIG. 2. FIG. 4 is a cross-sectional view illustrating an example of an output portion.

A spin wave waveguide structure 100 illustrated in FIGS. 1 to 4 includes an insulating magnetic film 12 and a periodic conductor film 14. The periodic conductor film 14 is disposed on at least one surface of both surfaces of the insulating magnetic film 12. In this example, the periodic conductor film 14 is formed on both surfaces of the insulating magnetic film 12 as illustrated in the cross-sectional view of FIG. 3. The periodic conductor film 14 further has a periodic structure as illustrated in FIGS. 1 and 2. Moreover, in the periodic structure of the periodic conductor film, the conductor film is formed of an assembly of fragment films 14a separated by a plurality of holes 15 and grooves 16 connecting the plurality of holes 15, and the fragment films 14a adjacent to each other are electrically insulated from each other by the holes 15 and the grooves 16.

As illustrated in FIG. 1, the spin wave waveguide structure 100 includes a portion where the periodic conductor film 14 is present on the insulating magnetic film 12, and a portion where the conductor film is not present on the insulating magnetic film. The portion of the insulating magnetic film 12 where the conductor film is not present functions as a spin wave waveguide. In FIG. 1, a spin wave waveguide direction 21 is illustrated with a broken line. It is necessary to provide no conductor film irrespective of periodicity in the portion of the insulating magnetic film 12 functioning as a spin wave waveguide.

With such a structure, the spin wave waveguide structure can guide spin waves without changing the shape of a magnetic material (insulating magnetic film 12).

The example illustrated in FIG. 1 is also an example in which an input portion 22 and an output portion 24 for spin waves are formed in of the insulating magnetic film 12 of the portion where the conductor film is not present. Such a spin wave waveguide structure including the input portion 22 and the output portion 24 can easily input and output spin waves.

In the example illustrated in FIG. 1, the portion where the conductor film is not present, in other words, the spin wave waveguide is formed between the input portion 22 and the output portion 24, and bent therebetween. Bend angles α and β are 120° in FIG. 1, but may be any other angle. For example, the bend angles α and β may be 90° to produce a waveguide that bends at a right angle. Alternatively, the bend angles α and β may be less than 90°, and for example, may be 10° to place an output terminal such that spin waves return immediately next to an input terminal. Note that, in the example illustrated in FIG. 1, a comparative output portion 26 is provided as an output portion in the portion where the periodic conductor film 14 is present (portion that is not a spin wave waveguide), but spin waves hardly propagate to the comparative output portion 26 as described later.

In the spin wave waveguide structure 100 illustrated in FIG. 1, the insulating magnetic film 12 is present in all regions including the input portion 22 and the output portion 24. The insulating magnetic film 12 is made of a magnetic material, preferably made of a magnetic garnet, and particularly preferably made of yttrium iron garnet (YIG). A magnetic material such as YIG inherently allows spin wave propagation, and spin waves propagate in the x-y plane in FIG. 1. Spin waves would propagate without restriction in the insulating magnetic film 12 with no conductor film 14 in FIG. 1, but with the structure illustrated in FIG. 1, it is possible to restrict spin wave propagation to a path functioning as a spin wave waveguide.

YIG is a magnetic body and is a magnetic insulator that is an insulator. YIG is based on Y₃Fe₅O₁₂ and may be a material in which the Y and Fe components are substituted with other elements. It is important that the material of the insulating magnetic film 12 of the present invention is magnetic and insulating, and is preferably a magnetic garnet, in particular, and among such materials, YIG is especially well known for its low damping constant, thereby enabling favorable spin wave propagation because a low damping constant results in small dissipation of spin waves. The damping constant of a material forming an insulating magnetic body is preferably 1×10⁻³ or less and 1×10⁻⁷ or more.

In the spin wave waveguide structure 100 of the present invention, the insulating magnetic film 12 may have a thickness of 1 mm or less. Such a thickness is sufficient to allow size reduction of the spin wave waveguide structure. The lower limit of the thickness of the insulating magnetic film 12 is not particularly limited but may be 0.01 µm or more, for example, for reasons such as processing ease.

In the spin wave waveguide structure 100 of the present invention, the periodic conductor film 14 may be made of any conductor material and contain at least one of copper, aluminum, gold, silver, platinum, iron, a transparent conductor, a superconductor, graphene, carbon nanotubes, an organic conductive material, and a conductive magnetic body. Among these, copper is particularly preferred.

As illustrated in FIGS. 1 and 2, each fragment film 14a preferably has a shape in which the angles of a triangle are rounded (particularly made of copper). The periodic conductor film 14 is a periodic structure constituted by the fragment films 14a being periodically disposed. The fragment films 14a adjacent to each other are not in contact with each other and are electrically insulated from each other. In a case where no material is formed between the adjacent fragment films 14a (holes 15 and grooves 16), the material is air, and the adjacent fragment films 14a are electrically insulated from each other. Since it is sufficient that the fragment films 14a are insulated from each other, the material between the adjacent fragment films 14a is not particularly limited as long as it is a non-magnetic and non-conductive material. In other words, the electric insulation between the fragment films 14a may be achieved by a non-magnetic and non-conductive material existing in at least a portion of the holes 15 and the grooves 16. Examples of such a material between the adjacent fragment films 14a include glass, silicon, silicone, and plastic. The non-magnetic and non-conductive material may fill all of the holes 15 and the grooves 16 or may be present in part of the holes 15 and the grooves 16. FIGS. 1 to 3 illustrate a case where nothing is formed between the adjacent fragment films 14a.

The periodic conductor film 14 constituted by a large number of fragment films 14a may have dimensions as described below. As illustrated in FIGS. 2 and 3, "d" represents the size of each hole 15, "g" represents the width of each straight groove 16 connecting holes 15, and "a" represents the distance between the centers of two holes 15. Since the adjacent holes 15 are connected by the straight grooves 16, the fragment films 14a are not in contact with each other but are isolated. Appropriate values of the structure sizes ("d", "g", "a", and the thicknesses of the conductor film and the insulating magnetic film 12) vary depending on the frequency and wavelength of spin waves as well as the physical properties of the magnetic material constituting the insulating magnetic film 12. In a case where the insulating magnetic film 12 is made of YIG and has a thickness of 10 µm and the material of the periodic conductor film 14 is copper, more specific dimensions of the constants "d", "g", and "a" may be 250 µm, 1 µm, and 450 µm, respectively.

The periodic conductor film 14 preferably has a thickness of 100 µm or less. Such a thickness of the periodic conductor film 14 is sufficient to allow size reduction. Furthermore, the lower limit of the thickness of the periodic conductor film 14 is not particularly limited but may be 0.001 µm or more, for example, for reasons such as processing ease.

As a more specific example, the periodic structure of the spin wave waveguide structure 100 may have upper and lower surfaces both covered with copper (conductor) having a thickness of 2 µm with periodically formed holes 15 and grooves 16 as illustrated in FIGS. 1 to 3.

Spin wave guiding is possible even if the periodic conductor film 14 is formed only on one surface of the insulating magnetic film 12. However, it is desirable that the periodic conductor films 14 are simultaneously present on both surfaces. This is because spin wave guiding can be more easily controlled. In a case where the periodic conductor films 14 are present on both surfaces of the insulating magnetic film 12, it is desirable that the periodic conductor films 14 on both surfaces are symmetrically present with respect to the insulating magnetic film 12.

The entire device of the spin wave waveguide structure 100 of the present invention may be formed on a supporting substrate. Specifically, the spin wave waveguide structure 100 may further include a supporting substrate (not illustrated), and the insulating magnetic film 12 and the periodic conductor film 14 may be disposed on the supporting substrate. In this manner, by further including the supporting substrate, the spin wave waveguide structure 100 can have an excellent mechanical strength. The supporting substrate is preferably at least one of a silicon substrate, a glass substrate, a garnet substrate, a dielectric substrate, a conductive substrate, an insulating substrate, a magnetic substrate, a non-magnetic substrate, a wooden substrate, and a stone substrate. The supporting substrate may have a thickness of 100 µm or more and 500 µm or less. As a more specific preferable example, the supporting substrate may be, for example, a silicon substrate, a glass substrate, or a garnet substrate having a thickness of several hundreds µm approximately.

As illustrated in FIGS. 1 and 4, a conductor film 23 of the input portion and a conductor film 25 of the output portion may be formed above the magnetic film 12 in the input portion 22 (input terminal) and the output portion 24 (output terminal), respectively. The conductor film 23 of the input portion and the conductor film 25 of the output portion may be, for example, gold films having a thickness of 30 nm. The gold films suppress unwanted reflected spin waves generated at end parts of the input terminal and the output terminal. These films are provided to facilitate performance check of the spin wave waveguide periodic structure and are well-known structures as disclosed in Non Patent Document 1 as well. The conductor film 23 of the input portion and the conductor film 25 of the output portion may contain at least one of gold, copper, aluminum, silver, platinum, iron, a transparent conductor, a superconductor, graphene, carbon nanotubes, an organic conductive material, and a conductive magnetic body.

The input portion 22 and the output portion 24 may have optional dimensions, but D1, D2, and D3 in FIGS. 1 and 4 may be 2 mm, 2 mm, and 0.3 mm, respectively. This is the same for the dimensions of the comparative output portion 26 and its conductor film 27.

### EXAMPLE

The present invention will be more specifically described below with reference to Example and Comparative Example of the present invention, but the present invention is not limited to these examples.

### [Example]

The spin wave waveguide structure illustrated in FIGS. 1 to 4 as the present invention structure was produced. The material of the insulating magnetic film 12 was YIG, and the material of the periodic conductor films 14 disposed on both surfaces of the insulating magnetic film 12 was copper. The periodic conductor films 14 on both surfaces of the insulating magnetic film 12 were symmetric to each other with respect to the insulating magnetic film 12. The conductor film 23 of the input portion 22, the conductor film 25 of the output portion 24, and the conductor film 27 of the comparative output portion 26 were all gold films. The physical properties of the materials were as follows.

### [Physical properties of YIG]

Specific dielectric constant: 15.3 (dimensionless)
Saturated magnetization: 1735 G
Gyromagnetic constant (= magnetogyric ratio): 2.8 MHz/Oe
Damping constant: 1×10⁻⁵ (dimensionless)
   A bias magnetic field was applied to YIG.
Bias magnetic field: uniformly applied to YIG in z direction with the magnitude of 2335 Oe

### [Physical properties of gold]

Electrical conductivity: 4.561×10⁷ S/m

### [Physical properties of copper]

Electrical conductivity: 5.96×10⁷ S/m

In addition, the thickness of the insulating magnetic film 12 was 10 µm, and the thickness of the periodic conductor film 14 was 2 µm. The constants "d", "g", and "a" of the holes 15 and the grooves 16 in the periodic conductor film 14 are 250 µm, 1 µm, and 450 µm, respectively. The dimensions D1, D2, and D3 of the input portion 22, the output portion 24, and the comparative output portion 26 were 2 mm, 2 mm, and 0.3 mm, respectively. The gold films on the input portion 22, the output portion 24, and the comparative output portion 26 had a thickness of 30 nm. The width of the portion (spin wave waveguide) where the conductor film is not present, which was formed between the input portion 22 and the output portion 24, was 6 mm, and the bend angles α and β were 120°.

Spin waves were input to the input portion 22 of the spin wave waveguide structure 100 thus configured.

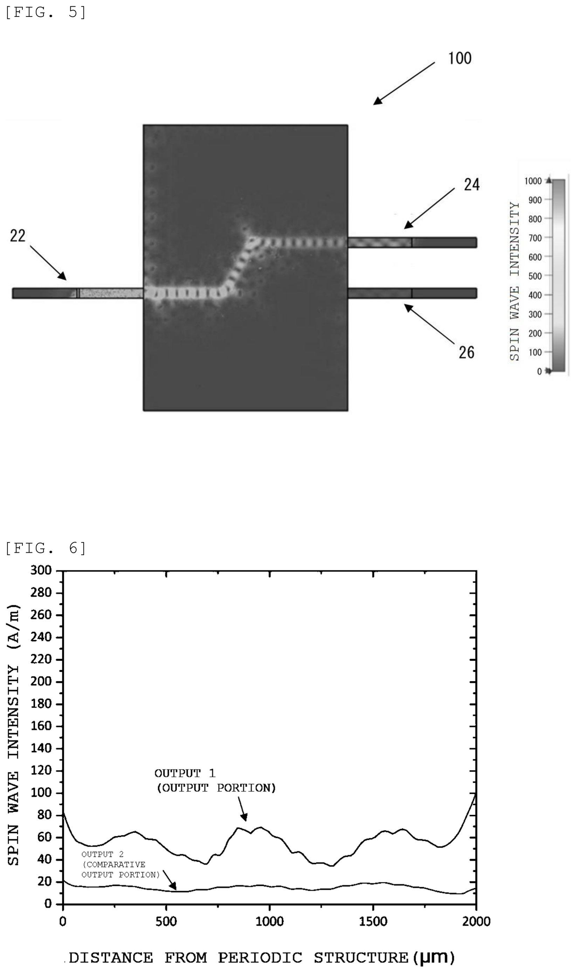

FIG. 5 illustrates a measurement result of the status of spin waves propagating through the above-described structure, which was obtained by installing microstrip-type antennas at the input terminal and the output terminal, respectively, and converting a magnetic field signal generated by spin waves into an electric signal. Shading indicates spin wave intensity. The observed frequency is 1.8 GHz.

In addition, FIG. 6 illustrates intensity distributions of spin waves measured at the output portion 24 and the comparative output portion 26, respectively. The average value at the output portion 24 was 50 A/m, and the average value at the comparative output portion 26 was 15 A/m. It can be said that spin waves were successfully controlled to flow to the output portion 24.

### [Comparative example]

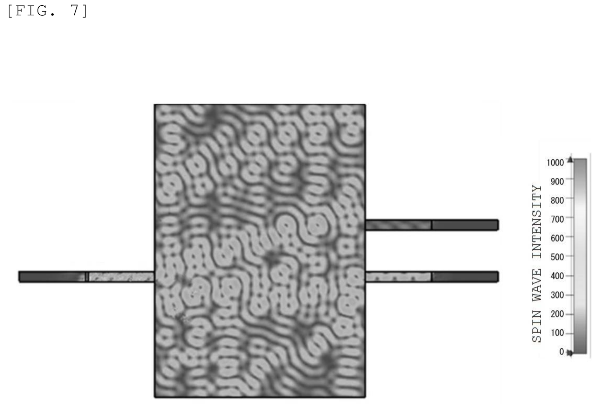

For comparison, FIG. 7 illustrates the status of spin waves in a case where there is no periodic structure due to the periodic conductor film 14. The structure has no copper above or below YIG. YIG is present, and the gold films of the input and output terminals are present as well. All the same dimensions are employed. The bias magnetic field applied to YIG and the observed frequency of spin waves are also the same as in Example.

In a case where there is no periodic structure, the straight-propagating component is largest in spin waves input from the input portion 22 of the input terminal, and thus the intensity at the output portion 26 is high. At the same time, spin waves spread while propagating, and accordingly, they are reflected at the ends of YIG and spread throughout the entire YIG.

### [Evaluation of Example and Comparative Example]

The propagating direction of spin waves cannot be restricted with the structure as in Comparative Example, but with a periodic structure as in Example, the propagating direction of spin waves can be restricted and controlled such that the spin waves can be transferred to the output portion 24. Accordingly, the intensity at the output portion 24 can be increased. In other words, it can be understood from the present example that spin wave guiding can be performed with the periodic structure. It is desirable that both the copper above and below YIG are present simultaneously. However, spin wave guiding is possible with only one of them. However, the above-described example in which copper films are provided on both surfaces has a better output ratio between the output portion 24 and the comparative output portion 26 than the case with only one surface. In Example, the waveguide bend angles are 120°, but a waveguide with other angles may be produced as described above. Moreover, although the waveguide of Example is a single line, the structure of the present invention is also applicable to cases where one waveguide branches into three or more lines as in Non Patent Document 1.

### INDUSTRIAL APPLICABILITY

Technologies for routing spin waves are essential for spin wave devices, which are expected to become next-generation computing devices. Since spin waves propagate through a magnetic material, conventional spin wave routing has employed methods for shaping the magnetic material into a line. This is modeled after the shape of electrical wiring in electronic devices. However, when a magnetic material in a spin wave device is subjected to a shape change like an electrical line in electrical wiring, magnetic properties unique to magnetic materials, known as shape magnetic anisotropy, change, which leads to a problem that spin wave propagation characteristics change and propagation efficiency significantly degrades. The present invention solves this problem by producing a conductor periodic structure above, below, or on both sides of the magnetic material without changing the shape of the magnetic material. The present method is expected to become the standard for spin wave routing in spin wave devices in the near future.

The ripple effects of the spin wave waveguide structure of the present invention on related fields are as follows.

### (1) Computer

The ripple effects include those on all fields currently using computers, as well as the fields of devices on which arithmetic elements, such as CPUs, are mounted. Among them, the present invention is particularly useful in situations where computers are needed on the millimeter or micrometer scale. Examples include sensors and microchips being mounted on portable instruments, wearable devices, and home electronics.

### (2) High-frequency, wireless, and communication fields

Spin waves are waves that respond in the order of GHz like microwaves, but their wavelength is shortened by a factor of 100 or more by converting them into waves that propagate through a magnetic body. In terms of device (element) size, this indicates that the entire chip can be reduced in size by a factor of 100. Conventionally, size reduction of analog high-frequency instruments has not significantly progressed, and their sizes remain far from being portable. Thus, realization of spin wave devices is expected to enable size reduction of high-frequency instruments.

The present description includes the following embodiments.
[1]: A spin wave waveguide structure for guiding spin waves, the spin wave waveguide structure comprising:
   an insulating magnetic film; and
   a periodic conductor film disposed on at least one surface of both surfaces of the insulating magnetic film, the periodic conductor film being formed of a conductor film having a periodic structure, wherein
   the periodic structure of the periodic conductor film is such that the conductor film is formed of an assembly of a plurality of fragment films, and the fragment films are such that the fragment films adjacent to each other are electrically insulated from each other,
   the electric insulation between the fragment films is due to the fragment films being separated by a plurality of holes and grooves connecting the plurality of holes or due to a non-magnetic and non-conductive material existing in at least a portion of the holes and grooves,
   the spin wave waveguide structure includes
      a portion where the periodic conductor film is present on the insulating magnetic film, and
      a portion where the conductor film is not present on the insulating magnetic film, and
   the insulating magnetic film of the portion where the conductor film is not present functions as a spin wave waveguide.
[2]: The spin wave waveguide structure according to the above [1], wherein the insulating magnetic film is formed of a magnetic garnet.
[3]: The spin wave waveguide structure according to the above [2], wherein the insulating magnetic film is formed of yttrium iron garnet.
[4]: The spin wave waveguide structure according to any of the above [1] to [3], wherein the conductor film contains at least one of copper, aluminum, gold, silver, platinum, iron, a transparent conductor, a superconductor, graphene, carbon nanotubes, an organic conductive material, and a conductive magnetic body.
[5]: The spin wave waveguide structure according to any of the above [1] to [4], wherein the insulating magnetic film has a thickness of 1 mm or less.
[6]: The spin wave waveguide structure according to any of the above [1] to [5], wherein the conductor film has a thickness of 100 µm or less.
[7]: The spin wave waveguide structure according to any of the above [1] to [6], wherein
   the spin wave waveguide structure further comprises a supporting substrate, and
   the insulating magnetic film and the periodic conductor film are disposed on the supporting substrate.
[8]: The spin wave waveguide structure according to the above [7], wherein the supporting substrate is at least one of a silicon substrate, a glass substrate, a garnet substrate, a dielectric substrate, a conductive substrate, an insulating substrate, a magnetic substrate, a non-magnetic substrate, a wooden substrate, and a stone substrate.
[9]: The spin wave waveguide structure according to the above [7] or [8], wherein the supporting substrate has a thickness of 100 µm or more and 500 µm or less.
[10]: The spin wave waveguide structure according to any of the above [1] to [9], wherein an input portion and an output portion for spin waves are formed in the insulating magnetic film of the portion where the conductor film is not present.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A spin wave waveguide structure for guiding spin waves, the spin wave waveguide structure comprising:
an insulating magnetic film; and
a periodic conductor film disposed on at least one surface of both surfaces of the insulating magnetic film, the periodic conductor film being formed of a conductor film having a periodic structure, wherein
the periodic structure of the periodic conductor film is such that the conductor film is formed of an assembly of a plurality of fragment films, and the fragment films are such that the fragment films adjacent to each other are electrically insulated from each other,
the electric insulation between the fragment films is due to the fragment films being separated by a plurality of holes and grooves connecting the plurality of holes or due to a non-magnetic and non-conductive material existing in at least a portion of the holes and grooves,
the spin wave waveguide structure includes
a portion where the periodic conductor film is present on the insulating magnetic film, and
a portion where the conductor film is not present on the insulating magnetic film, and
the insulating magnetic film of the portion where the conductor film is not present functions as a spin wave waveguide.

2. The spin wave waveguide structure according to claim 1, wherein the insulating magnetic film is formed of a magnetic garnet.

3. The spin wave waveguide structure according to claim 2, wherein the insulating magnetic film is formed of yttrium iron garnet.

4. The spin wave waveguide structure according to claim 1, wherein the conductor film contains at least one of copper, aluminum, gold, silver, platinum, iron, a transparent conductor, a superconductor, graphene, carbon nanotubes, an organic conductive material, and a conductive magnetic body.

5. The spin wave waveguide structure according to claim 1, wherein the insulating magnetic film has a thickness of 1 mm or less.

6. The spin wave waveguide structure according to claim 1, wherein the conductor film has a thickness of 100 µm or less.

7. The spin wave waveguide structure according to any one of claims 1 to 6, wherein
the spin wave waveguide structure further comprises a supporting substrate, and
the insulating magnetic film and the periodic conductor film are disposed on the supporting substrate.

8. The spin wave waveguide structure according to claim 7, wherein the supporting substrate is at least one of a silicon substrate, a glass substrate, a garnet substrate, a dielectric substrate, a conductive substrate, an insulating substrate, a magnetic substrate, a non-magnetic substrate, a wooden substrate, and a stone substrate.

9. The spin wave waveguide structure according to claim 7, wherein the supporting substrate has a thickness of 100 µm or more and 500 µm or less.

10. The spin wave waveguide structure according to claim 1, wherein an input portion and an output portion for spin waves are formed in the insulating magnetic film of the portion where the conductor film is not present.
